(19) 

Europäisches
Patentamt
European
Patent Office
Office européen
des brevets

(11) **EP 4 679 112 A1**

(12) **EUROPEAN PATENT APPLICATION**
published in accordance with Art. 153(4) EPC

(43) Date of publication:
**14.01.2026 Bulletin 2026/03**

(21) Application number: 24766458.4

(22) Date of filing: **06.03.2024**

(51) International Patent Classification (IPC):
*G01R 31/367* (2019.01)    *G01R 31/392* (2019.01)
*G01R 31/382* (2019.01)

(52) Cooperative Patent Classification (CPC):
Y02E 60/10

(86) International application number:
**PCT/CN2024/080225**

(87) International publication number:
**WO 2024/183743 (12.09.2024 Gazette 2024/37)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **06.03.2023 CN 202310201342**

(71) Applicant: **Huaneng Clean Energy Research
Institute
Beijing 102209 (CN)**

(72) Inventors:
• **DUAN, Zhaorong
Beijing 102209 (CN)**
• **LIU, Mingyi
Beijing 102209 (CN)**

• **CAO, Chuanzhao
Beijing 102209 (CN)**
• **CAO, Xi
Beijing 102209 (CN)**
• **PEI, Jie
Beijing 102209 (CN)**
• **CHENG, Qian
Beijing 102209 (CN)**
• **PING, Xiaofan
Beijing 102209 (CN)**
• **YANG, Chaoran
Beijing 102209 (CN)**
• **WANG, Luyao
Beijing 102209 (CN)**

(74) Representative: **Handsome I.P. Ltd
27-28 Monmouth Street
Bath BA1 2AP (GB)**

(54) **ONLINE PREDICTION METHOD AND APPARATUS FOR RESIDUAL LIFE OF ENERGY STORAGE BATTERY**

(57)    A method for predicting the remaining useful life of an energy storage battery online, a device, electronic equipment, storage medium, computer program product and computer program thereof, are disclosed. The method includes: obtaining energy storage battery sampled data corresponding to a plurality of identical sampled energy storage batteries under different sampled depths of charge-discharge respectively to establish a mapping relationship among a capacity degradation rate, cumulative discharge energy, and a depth of charge-discharge corresponding to the energy storage battery according to the energy storage battery sampled data; obtaining single depth of discharge and single cumulative discharge energy of a target energy storage battery in each discharge process from a first discharge to a current moment, and obtaining a single capacity degradation rate and an average single capacity degradation rate of the target energy storage battery by combining the mapping relationship; obtaining a current capacity degradation rate of the target energy storage battery according to the single capacity degradation rate corresponding to each discharge process; and obtaining a preset maximum capacity degradation rate corresponding to the target energy storage battery, and obtaining the remaining useful life of the target energy storage battery by combining the current capacity degradation rate and the average single capacity degradation rate.

EP 4 679 112 A1

obtaining energy storage battery sampled data corresponding to a plurality of identical sampled energy storage batteries under different sampled depths of charge-discharge respectively, and establishing a mapping relationship among a capacity degradation rate, cumulative discharge energy, and a depth of charge-discharge corresponding to the energy storage battery according to the energy storage battery sampled data — S101

obtaining single depth of discharge and single cumulative discharge energy of the target energy storage battery in each discharge process from a first discharge to a current moment, and obtaining a single capacity degradation rate of the target energy storage battery and an average single capacity degradation rate of the target energy storage battery according to the single cumulative discharge energy, the single depth of discharge and the mapping relationship — S102

obtaining a current capacity degradation rate corresponding to the current moment of the target energy storage battery according to the single capacity degradation rate corresponding to each discharge process of the target energy storage battery — S103

obtaining a preset maximum capacity degradation rate corresponding to the target energy storage battery, and obtaining the remaining useful life of the target energy storage battery by combining the current capacity degradation rate and the average single capacity degradation rate, wherein the remaining useful life refers to a remaining number of charge-discharge cycles of the target energy storage battery — S104

**FIG. 1**

Description

CROSS-REFERENCE TO RELATED APPLICATIONS

The application claims the priority of Chinese Patent Application No. 2023102013429 filed in China on March 6, 2023, which is incorporated by reference in its entirety.

TECHNICAL FIELD

The present disclosure relates to the field of battery technology, and specifically relates to a method and device for predicting remaining useful life of an energy storage battery online, electronic device, storage medium, computer program product, and computer program.

BACKGROUND

The remaining useful life of the energy storage battery refers to the remaining number of cycles of the energy storage battery when the battery capacity or energy has degraded to a specified value, which may be affected by various factors, such as charge-discharge power of the battery, depth of charge-discharge, and ambient temperature. During the actual operation process of the energy storage battery, mastering the remaining useful life of the energy storage battery may provide a basis for optimization of operation strategies, system maintenance, and economic evaluation. However, at present, neither the energy storage battery management system nor the monitoring system of energy storage power stations is equipped with the corresponding remaining useful life prediction function. The research of the remaining useful life of the energy storage battery may be still mainly conducted in laboratories: establishing the relationship between the battery capacity (energy) degradation rate and the number of cycles by carrying out cycle experiments under fixed charge-discharge power and fixed depth of charge-discharge for the battery, therefore predicting the remaining useful life of energy storage batteries.

Nevertheless, under different application scenarios, the operating conditions of energy storage battery vary greatly. Even for the same energy storage battery, the depth of charge-discharge changes constantly each time. Meanwhile, since the capacity (energy) degradation rate of energy storage battery and the depth of charge-discharge may be a non-linear relationship, the remaining useful life prediction models currently established in laboratories under fixed depth of charge-discharge cannot well meet the requirement of engineering applications.

SUMMARY

The present disclosure is intended to solve at least one of the technical problems in the related art to a certain extent.

Embodiments of a first aspect of the present disclosure provide a method for predicting the remaining useful life of an energy storage battery online, which includes obtaining energy storage battery sampled data corresponding to a plurality of identical sampled energy storage batteries under different sampled depths of charge-discharge respectively, and establishing a mapping relationship among a capacity degradation rate, cumulative discharge energy, and a depth of charge-discharge corresponding to the energy storage battery according to the energy storage battery sampled data, wherein the expression of the mapping relationship is:

wherein, ELR is the capacity degradation rate, $Add_E$ is the cumulative discharge energy, x is the depth of discharge with a value range of 0-100%, and a, b, c, d are fitting parameters; obtaining single depth of discharge and single cumulative discharge energy of a target energy storage battery in each discharge process from a first discharge to a current moment, and obtaining a single capacity degradation rate of the target energy storage battery and an average single capacity degradation rate of the target energy storage battery according to the single cumulative discharge energy, the single depth of discharge and the mapping relationship; obtaining a current capacity degradation rate corresponding to the current moment of the target energy storage battery according to the single capacity degradation rate corresponding to each discharge process of the target energy storage battery; and obtaining a preset maximum capacity degradation rate corresponding to the target energy storage battery, and obtaining the remaining useful life of the target energy storage battery by combining the current capacity degradation rate and the average single capacity degradation rate, wherein the remaining useful life refers to a remaining number of charge-discharge cycles of the target energy storage battery.

Embodiments of a second aspect of the present disclosure provide an device for predicting the remaining useful life of an energy storage battery online.

Embodiments of the third aspect of the present disclosure provide an electronic device.

Embodiments of the fourth aspect of the present disclosure provide a non-transitory computer-readable storage medium.

Embodiments of the fifth aspect of the present disclosure provide a computer program product.

Embodiments of the sixth aspect of the present disclosure provide a computer program.

Embodiments of a first aspect of the present disclosure provide a method for predicting the remaining useful life of an energy storage battery online, which includes obtaining energy storage battery sampled data corresponding to a plurality of identical sampled energy storage batteries under different sampled depths of charge-discharge respectively, and establishing a mapping relationship among a capacity degradation rate, cumulative discharge energy, and a depth of charge-discharge corresponding to the energy storage battery according to the energy storage battery sampled data, wherein the expression of the mapping relationship is:

wherein, ELR is the capacity degradation rate, $Add_E$ is the cumulative discharge energy, x is the depth of discharge with a value range of 0-100%, and a, b, c, d are fitting parameters; obtaining single depth of discharge and single cumulative discharge energy of a target energy storage battery in each discharge process from a first discharge to a current moment, and obtaining a single capacity degradation rate of the target energy storage battery and an average single capacity degradation rate of the target energy storage battery according to the single cumulative discharge energy, the single depth of discharge and the mapping relationship; obtaining a current capacity degradation rate corresponding to the current moment of the target energy storage battery according to the single capacity degradation rate corresponding to each discharge process of the target energy storage battery; and obtaining a preset maximum capacity degradation rate corresponding to the target energy storage battery, and obtaining the remaining useful life of the target energy storage battery by combining the current capacity degradation rate and the average single capacity degradation rate, wherein the remaining useful life refers to a remaining number of charge-discharge cycles of the target energy storage battery.

According to one embodiment of the present disclosure, establishing the mapping relationship among the capacity degradation rate, the cumulative discharge energy, and the depth of charge-discharge corresponding to the energy storage battery according to the energy storage battery sampled data includes: fitting the energy storage battery sampled data to establish the mapping relationship among the capacity degradation rate, the cumulative discharge energy, and the depth of charge-discharge corresponding to the energy storage battery, wherein each sampled energy storage battery corresponds to one sampled depth of charge-discharge, and the energy storage battery sampled data comprises sampled depth of charge-discharge corresponding to each sampled energy storage battery, sampled capacity degradation rate and sampled cumulative discharge energy of each sampled energy storage battery under corresponding sampled depth of charge-discharge.

According to one embodiment of the present disclosure, obtaining the energy storage battery sampled data corresponding to a plurality of identical sampled energy storage batteries under different sampled depths of charge-discharge respectively comprises: performing cyclic charge-discharge on the plurality of the sampled energy storage batteries at different sampled depths of charge-discharge respectively with a specific power; for any one of the sampled energy storage batteries, after a preset number of cycles, performing energy calibration on the sampled energy storage battery, and recording calibrated discharge energy of the sampled energy storage battery under corresponding sampled depths of charge-discharge, wherein the calibrated discharge energy refers to total energy released by the sampled energy storage battery from a fully charged state to a fully discharged state during calibration; obtaining rated energy of the sampled energy storage battery; For any one of the sampled energy storage batteries, obtaining the sampled capacity degradation rate of the sampled energy storage battery under the corresponding sampled depth of charge-discharge according to the calibrated discharge energy and the rated energy of the sampled energy storage battery under the corresponding sampled depth of charge-discharge; and generating the energy storage battery sampled data according to the plurality of sampled depth of charge-discharge, and the sampled capacity degradation rate and sampled cumulative discharge energy of the sampled energy storage battery under each of the sampled depth of charge-discharge.

According to one embodiment of the present disclosure, obtaining the single depth of discharge of the target energy storage battery in each discharge process from the first discharge to the current moment includes: during each single discharge process of the target energy storage battery, obtaining discharge start moment of the target energy storage battery and an initial state of charge of the target energy storage battery at the discharge start moment, and obtaining discharge end moment of the target energy storage battery and the end state of charge of the target energy storage battery at the discharge end moment; and determining difference between the initial state of charge and the end state of charge as the single depth of discharge corresponding to the target energy storage battery in the current discharge process.

According to one embodiment of the present disclosure, obtaining the average single capacity degradation rate includes: obtaining sum of all the single capacity degradation rates corresponding to each discharge process of the target energy storage battery from the first discharge to the current moment; obtaining a total number of discharges of the target energy storage battery from the first discharge to the current moment; and determining quotient of the sum and the total number of discharges as the average single capacity degradation rate.

According to one embodiment of the present disclosure, obtaining the average single capacity degradation rate includes: calculating average of the single depths of discharge in each discharge process of the target energy storage battery from the first discharge to the current moment to obtain the average depth of discharge of the target energy storage battery from the first discharge to the current moment; calculating average of the single cumulative discharge energies in each discharge process of the target energy storage battery from the first discharge to the current moment to obtain the average single cumulative discharge energy of the target energy storage battery from the first discharge to the current moment; and obtaining the average single capacity degradation rate according to the average depth of discharge, the average single cumulative discharge energy and the mapping relationship.

According to one embodiment of the present disclosure, obtaining the current capacity degradation rate corresponding to the current moment of the target energy storage battery according to the single capacity degradation rate corresponding to each discharge process of the target energy storage battery comprises: obtaining sum of all the single capacity degradation rates corresponding to each discharge process of the target energy storage battery from the first discharge to the current moment, and determining the sum as the current capacity degradation rate.

Embodiments of a second aspect of the present disclosure provide a device for predicting the remaining useful life of an energy storage battery online, which includes: a relationship establishing module, configured to obtain energy storage battery sampled data corresponding to a plurality of identical sampled energy storage batteries under different sampled depths of charge-discharge respectively, and establish a mapping relationship among a capacity degradation rate, cumulative discharge energy, and a depth of charge-discharge corresponding to the energy storage battery according to the energy storage battery sampled data, wherein the expression of the mapping relationship is: wherein, ELR is the capacity degradation rate, $Add_E$ is the cumulative discharge energy, x is the depth of discharge with a value range of 0-100%, and a, b, c, d are fitting parameters; a first obtaining module, configured to obtain single depth of discharge and single cumulative discharge energy of a target energy storage battery in each discharge process from a first discharge to a current moment, and obtain a single capacity degradation rate of the target energy storage battery and an average single capacity degradation rate of the target energy storage battery according to the single cumulative discharge energy, the single depth of discharge and the mapping relationship; a second obtaining module, configured to obtain a current capacity degradation rate corresponding to the current moment of the target energy storage battery according to the single capacity degradation rate corresponding to each discharge process of the target energy storage battery; and a third obtaining module, configured to obtain a preset maximum capacity degradation rate corresponding to the target energy storage battery, and obtain the remaining useful life of the target energy storage battery by combining the current capacity degradation rate and the average single capacity degradation rate, wherein the remaining useful life refers to a remaining number of charge-discharge cycles of the target energy storage battery.

According to one embodiment of the present disclosure, the relationship establishing module is further configured to fit the energy storage battery sampled data to establish the mapping relationship among the capacity degradation rate, the cumulative discharge energy, and the depth of charge-discharge corresponding to the energy storage battery, wherein each sampled energy storage battery corresponds to one sampled depth of charge-discharge, and the energy storage battery sampled data comprises sampled depth of charge-discharge corresponding to each sampled energy storage battery, sampled capacity degradation rate and sampled cumulative discharge energy of each sampled energy storage battery under corresponding sampled depth of charge-discharge.

According to one embodiment of the present disclosure, the relationship establishing module is further configured to: perform cyclic charge-discharge on the plurality of the sampled energy storage batteries at different sampled depths of charge-discharge respectively with a specific power; for any one of the sampled energy storage batteries, after a preset number of cycles, perform energy calibration on the sampled energy storage battery, and record calibrated discharge energy of the sampled energy storage battery under corresponding sampled depths of charge-discharge, wherein the calibrated discharge energy refers to total energy released by the sampled energy storage battery from a fully charged state to a fully discharged state during calibration; obtain rated energy of the sampled energy storage battery; For any one of the sampled energy storage batteries, obtain the sampled capacity degradation rate of the sampled energy storage battery under the corresponding sampled depth of charge-discharge according to the calibrated discharge energy and the rated energy of the sampled energy storage battery under the corresponding sampled depth of charge-discharge; and generate the energy storage battery sampled data according to the plurality of sampled depth of charge-discharge, and the sampled capacity degradation rate and sampled cumulative discharge energy of the sampled energy storage battery under each of the sampled depth of charge-discharge.

According to one embodiment of the present disclosure, the first obtaining module is further configured to: during each single discharge process of the target energy storage battery, obtain discharge start moment of the target energy storage battery and an initial state of charge of the target energy storage battery at the discharge start moment, and obtain discharge end moment of the target energy storage battery and the end state of charge of the target energy storage battery at the discharge end moment; and determine difference between the initial state of charge and the end state of charge as the single depth of discharge corresponding to the target energy storage battery in the current discharge process.

According to one embodiment of the present disclosure, the first obtaining module is further configured to: obtain sum of all the single capacity degradation rates corresponding to each discharge process of the target energy storage battery from the first discharge to the current moment; obtain a total number of discharges of the target energy storage battery from the first discharge to the current moment; and determine quotient of the sum and the total number of discharges as the average single capacity degradation rate.

According to one embodiment of the present disclosure, the first obtaining module is further configured to: calculate average of the single depths of discharge in each discharge process of the target energy storage battery from the first discharge to the current moment to obtain the average depth of discharge of the target energy storage battery from the first discharge to the current moment; calculate average of the single cumulative discharge energies in each discharge process of the target energy storage battery from the first discharge to the current moment to obtain the average single cumulative discharge energy of the target energy storage battery from the first discharge to the current moment; and obtain the average single capacity degradation rate according to the average depth of discharge, the average single cumulative discharge energy and the mapping relationship.

According to one embodiment of the present disclosure, the second obtaining module is further configured to obtain sum of all the single capacity degradation rates corresponding to each discharge process of the target energy storage battery from the first discharge to the current moment, and determine the sum as the current capacity degradation rate.

Embodiments of a third aspect of the present disclosure provide an electronic device, which includes: at least one processor; and a memory communicatively connected to the at least one processor; wherein the memory stores instructions executable by the at least one processor, and the instructions are executed by the at least one processor, enabling the at least one processor to implement the method for predicting the remaining useful life of the energy storage battery online as described in any embodiment of the first aspect of the present disclosure.

Embodiments of a fourth aspect of the present disclosure provide a non-transitory computer-readable storage medium storing computer instructions, wherein the computer instructions are used to implement the method for predicting the remaining useful life of the energy storage battery online as described in any embodiment of the first aspect of the present disclosure.

Embodiments of a fifth aspect of the present disclosure provide a computer program product, including a computer program, When executed by a processor, the computer program is used to implement the method for predicting the remaining useful life of the energy storage battery online as described in any embodiment of the first aspect of the present disclosure.

Embodiments of a sixth aspect of the present disclosure provide computer program, comprising computer program code, which enabling a computer to implement the method for predicting the remaining useful life of the energy storage battery online as described in any embodiment of the first aspect of the present disclosure.

The present disclosure may achieves at least the following beneficial effects:

By conducting charge-discharge experiments on sampled energy storage batteries under different depths of discharge, the present disclosure establishes the mapping relationship among the capacity degradation rate, the cumulative discharge energy, and the depth of charge-discharge corresponding to energy storage batteries. And then, based on the single depth of discharge and the single cumulative discharge energy of the target energy storage battery in each discharge process during its actual operation, the current degradation rate of the target energy storage battery may be estimated, thereby realizing accurate online prediction of its remaining useful life.

## BRIEF DESCRIPTION OF DRAWINGS

The above-mentioned and/or additional aspects and advantages of the present disclosure will become apparent and easily understandable from the following description of the embodiments in conjunction with the drawings, wherein:

FIG. 1 is a schematic diagram illustrating an implementation of a method for predicting the remaining useful life of an energy storage battery online according to an embodiment of the present disclosure;

FIG. 2 is a schematic diagram illustrating an implementation of a method for predicting the remaining useful life of an energy storage battery online according to an embodiment of the present disclosure;

FIG. 3 is a schematic diagram of a device for predicting the remaining useful life of an energy storage battery online according to an embodiment of the present disclosure;

FIG. 4 is a schematic diagram of an electronic device according to an embodiment of the present disclosure.

## DETAILED DESCRIPTION

The embodiments of the present disclosure are described in detail below. Examples of the embodiments are shown in the drawings, wherein the same or similar reference numerals denote the same or similar elements or elements having the same or similar functions throughout. The embodiments described below with reference to the drawings are exemplary and are intended to explain the present disclosure, and may not be construed as limiting the present disclosure.

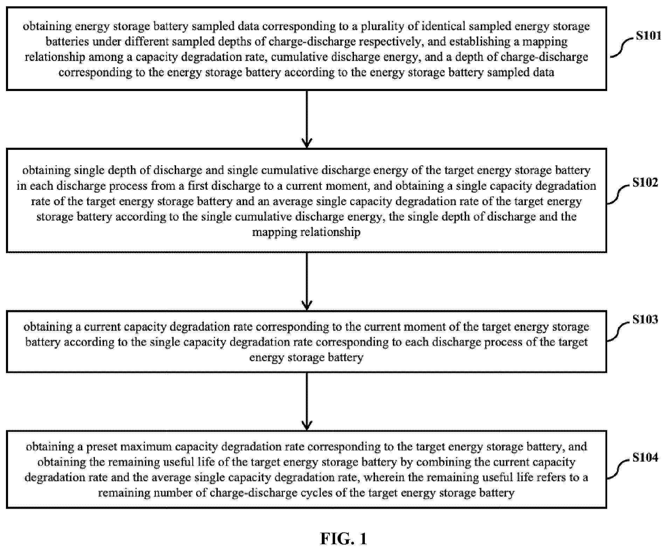

FIG. 1 is a schematic diagram illustrating an implementation of a method for predicting the remaining useful life of an energy storage battery online according to an embodiment of the first aspect of the present disclosure. As shown in FIG.

1, the method for predicting the remaining useful life of an energy storage battery online includes the following steps S101 to S104.

S101, Obtaining energy storage battery sampled data corresponding to a plurality of identical sampled energy storage batteries under different sampled depths of charge-discharge respectively, and establishing a mapping relationship among a capacity degradation rate, cumulative discharge energy, and a depth of charge-discharge corresponding to the energy storage battery according to the energy storage battery sampled data.

Cyclic charge-discharge may be performed on a plurality of sampled energy storage batteries at different sampled depths of charge-discharge respectively with a specific power. For any sampled energy storage battery, after a preset number of cycles, energy calibration may be conducted on the sampled energy storage battery, and the calibrated discharge energy of the sampled energy storage battery under its corresponding sampled depth of charge-discharge may be recorded. The calibrated discharge energy refers to the total energy released by the sampled energy storage battery from a fully charged state to a fully discharged state during calibration. In some embodiments, under a room temperature environment (25 ± 5 °C), cyclic charge-discharge is performed on the plurality of sampled energy storage batteries at different sampled depths of charge-discharge with a power of 0.5P. In some embodiments, the depths of charge-discharge may be selected as 100%, 80%, 50%, and 20% respectively for cyclic charging, and the number of cycles is set to 50.

The rated energy of the sampled energy storage battery is obtained, wherein the rated energy is the rated energy of the sampled energy storage battery at manufacture.

For any sampled energy storage battery, the sampled capacity degradation rate of the sampled energy storage battery under the corresponding sampled depth of charge-discharge is obtained according to the calibrated discharge energy and the rated energy of the sampled energy storage battery under the corresponding sampled depth of charge-discharge. Understandably, since the sampled energy storage battery has multiple calibrated discharge energies, multiple sampled capacity degradation rates may be obtained correspondingly.

Energy storage battery sampled data may be generated according to the plurality of sampled depths of charge-discharge, and the sampled capacity degradation rate and sampled cumulative discharge energy of the sampled energy storage battery under each sampled depth of charge-discharge; and the mapping relationship among the capacity degradation rate, the cumulative discharge energy, and the depth of charge-discharge corresponding to the energy storage battery is established based on the energy storage battery sampled data.

S102: Obtaining single depth of discharge and single cumulative discharge energy of the target energy storage battery in each discharge process from a first discharge to a current moment, and obtaining a single capacity degradation rate of the target energy storage battery and an average single capacity degradation rate of the target energy storage battery according to the single cumulative discharge energy, the single depth of discharge and the mapping relationship.

The single depth of discharge and the single cumulative discharge energy of the target energy storage battery in each discharge process from the first discharge to the current moment is obtained, and then the single capacity degradation rate of the target energy storage battery may be obtained by substituting the single cumulative discharge energy and single depth of discharge into the mapping relationship among the capacity degradation rate, the cumulative discharge energy, and the depth of charge-discharge corresponding to the energy storage battery.

The sum of all single capacity degradation rates corresponding to each discharge process of the target energy storage battery from the first discharge to the current moment may be obtained, and the total number of discharges of the target energy storage battery from the first discharge to the current moment may be obtained. And then the quotient of the sum and the total number of discharges may be determined as the average single capacity degradation rate.

S103: Obtaining a current capacity degradation rate corresponding to the current moment of the target energy storage battery according to the single capacity degradation rate corresponding to each discharge process of the target energy storage battery.

The sum of all single capacity degradation rates corresponding to each discharge process of the target energy storage battery from the first discharge to the current moment may be obtained, and the sum may be determined as the current capacity degradation rate.

S104: Obtaining a preset maximum capacity degradation rate corresponding to the target energy storage battery, and obtaining the remaining useful life of the target energy storage battery by combining the current capacity degradation rate and the average single capacity degradation rate, wherein the remaining useful life refers to a remaining number of charge-discharge cycles of the target energy storage battery.

The preset maximum capacity degradation rate corresponding to the target energy storage battery may be obtained, and then the remaining useful life of the target energy storage battery may be obtained by combining the current capacity degradation rate and the average single capacity degradation rate, wherein the remaining useful life refers to the remaining number of charge-discharge cycles of the target energy storage battery, wherein

$$\frac{preset\ maximum\ capacity\ degradation\ rate - current\ capacity\ degragation\ rate}{average\ single\ capacity\ degradation\ rate}$$

The embodiments of the present disclosure provides a method for predicting the remaining useful life of the energy storage battery online. The method includes: obtaining the energy storage battery sampled data corresponding to a plurality of identical sampled energy storage batteries under different sampled depths of charge-discharge respectively, and establishing the mapping relationship among the capacity degradation rate, the cumulative discharge energy, and the depth of charge-discharge corresponding to the energy storage battery according to the energy storage battery sampled data; obtaining the single depth of discharge and the single cumulative discharge energy of the target energy storage battery in each discharge process from the first discharge to the current moment, and obtaining the single capacity degradation rate of the target energy storage battery and the average single capacity degradation rate of the target energy storage battery according to the single cumulative discharge energy, the single depth of discharge and the mapping relationship; obtaining the current capacity degradation rate corresponding to the current moment of the target energy storage battery according to the single capacity degradation rate corresponding to each discharge process of the target energy storage battery; obtaining the preset maximum capacity degradation rate corresponding to the target energy storage battery, and obtaining the remaining useful life of the target energy storage battery by combining the current capacity degradation rate and the average single capacity degradation rate, wherein the remaining useful life refers to a remaining number of charge-discharge cycles of the target energy storage battery. In the embodiment of the present disclosure, by conducting charge-discharge experiments on sampled energy storage batteries under different depths of discharge, the mapping relationship among the capacity degradation rate, the cumulative discharge energy, and the depth of charge-discharge corresponding to the energy storage battery is established. Then, based on the single depth of discharge and the single cumulative discharge energy of the target energy storage battery in each discharge process during its actual operation, the current capacity degradation rate of the target energy storage battery is estimated, thereby realizing accurate online prediction of its remaining useful life.

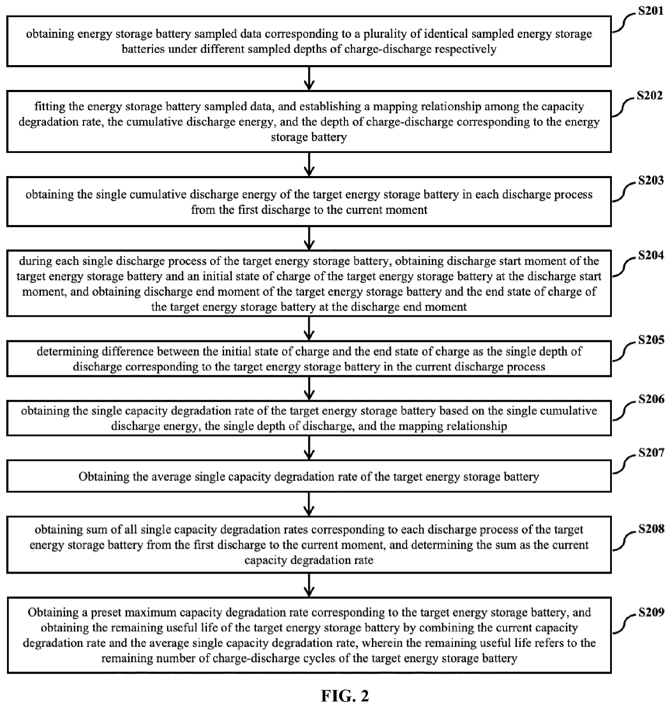

FIG. 2 is a schematic diagram illustrating an implementation of a method for predicting the remaining useful life of an energy storage battery online according to an embodiment of the first aspect of the present disclosure. As shown in FIG. 2, the method for predicting the remaining useful life of an energy storage battery online includes the following steps S201 to S209.

S201: Obtaining energy storage battery sampled data corresponding to a plurality of identical sampled energy storage batteries under different sampled depths of charge-discharge respectively.

Cyclic charge-discharge may be performed on the plurality of sampled energy storage batteries at different sampled depths of charge-discharge respectively with a specific power. For any sampled energy storage battery, after a preset number of cycles, energy calibration may be performed on the sampled energy storage battery, and the calibrated discharge energy Ei of the sampled energy storage battery under its corresponding sampled depth of charge-discharge may be recorded. The calibrated discharge energy refers to the total energy released by the sampled energy storage battery from a fully charged state to a fully discharged state during calibration.

In some embodiments, under a room temperature environment (25 $\pm$ 5 °C ), cyclic charge-discharge is performed on the plurality of sampled energy storage batteries at different sampled depths of charge-discharge with a power of 0.5P. In some embodiments, the depths of charge-discharge may be selected as 100%, 80%, 50%, and 20% respectively for cyclic charging, and the number of cycles is set to 50.

Specifically, when performing cyclic charge-discharge at a 100% depth of charge-discharge on sampled energy storage battery A, firstly, the sampled energy storage battery A is charged to a State of Charge (SOC) of 100%, then fully discharge it; next, the sampled energy storage battery A is charged to the SOC of 100% again, and then fully discharge it once more. The process may be repeated 50 cycles, and the energy calibration is performed on the sampled energy storage battery A at a power of 0.5P. Specifically, the total energy released by the sampled energy storage battery A from a fully charged state to a fully discharged state may be obtained and be determined as the first calibrated discharge energy of the sampled energy storage battery A. Further, the process of charging sampled energy storage battery A to the SOC of 100% and then fully discharging it may be continued for another 50 cycles. That is, after completing the 100th cycle of the sampled energy storage battery A, the total energy released by the sampled energy storage battery A from the fully charged state to the fully discharged state may be obtained, and be determined as the second calibrated discharge energy of sampled energy storage battery A. The process is repeated analogously.

Specifically, when performing cyclic charge-discharge at an 80% depth of charge-discharge on the sampled energy storage battery B, firstly, the sampled energy storage battery B is charged to an SOC of 90%, then discharge it to an SOC of 10%; next, the sampled energy storage battery B is charged to the SOC of 90% again, and then discharge it to the SOC of 10% once more. The process may be repeated 50 cycles, and the energy calibration is performed on the sampled energy storage battery B at a power of 0.5P. specifically, the total energy released by sampled energy storage battery B from a fully charged state to a fully discharged state may be obtained, and be determined as the first calibrated discharge energy of sampled energy storage battery B. Further, the process of charging sampled energy storage battery B to the SOC of 90% and then discharging it to the SOC of 10% may be continued for another 50 cycles. That is, after completing the 100th cycle of the sampled energy storage battery B, the total energy released by sampled energy storage battery B from the fully charged state to the fully discharged state may be obtained, and be determined as the second calibrated discharge energy of sampled energy storage battery B. The process is repeated analogously.

Specifically, when performing cyclic charge-discharge at an 50% depth of charge-discharge on the sampled energy storage battery C, firstly, the sampled energy storage battery C is charged to an SOC of 75%, then discharge it to an SOC of 25%; next, the sampled energy storage battery C is charged to the SOC of 75% again, and then discharge it to the SOC of 25% once more. The process may be repeated 50 cycles, and the energy calibration is performed on the sampled energy storage battery C at a power of 0.5P. Specifically, the total energy released by sampled energy storage battery C from a fully charged state to a fully discharged state may be obtained, and be determined as the first calibrated discharge energy of sampled energy storage battery C. Further, the process of charging sampled energy storage battery C to the SOC of 75% and then discharging it to the SOC of 25% may be continued for another 50 cycles. That is, after completing the 100th cycle of the sampled energy storage battery C, the total energy released by sampled energy storage battery C from the fully charged state to the fully discharged state may be obtained, and be determined as the second calibrated discharge energy of sampled energy storage battery C. The process is repeated analogously.

Specifically, when performing cyclic charge-discharge at an 20% depth of charge-discharge on the sampled energy storage battery D, firstly, the sampled energy storage battery D is charged to an SOC of 60%, then discharge it to an SOC of 40%; next, the sampled energy storage battery D is charged to the SOC of 60% again, and then discharge it to the SOC of 40% once more. The process may be repeated 50 cycles, and the energy calibration is performed on the sampled energy storage battery D at a power of 0.5P. Specifically, the total energy released by sampled energy storage battery D from a fully charged state to a fully discharged state may be obtained, and be determined as the first calibrated discharge energy of sampled energy storage battery D. Further, the process of charging sampled energy storage battery D to the SOC of 60% and then discharging it to the SOC of 40% may be continued for another 50 cycles. That is, after completing the 100th cycle of the sampled energy storage battery D, the total energy released by sampled energy storage battery D from the fully charged state to the fully discharged state may be obtained, and be determined as the second calibrated discharge energy of sampled energy storage battery D. The process is repeated analogously.

The rated energy of the sampled energy storage battery may be obtained, wherein the rated energy refers to the rated energy of the sampled energy storage battery at manufacture.

For any sampled energy storage battery, the sampled capacity degradation rate of the sampled energy storage battery under the corresponding sampled depth of charge-discharge is obtained according to the calibrated discharge energy and the rated energy of the sampled energy storage battery under its corresponding sampled depth of charge-discharge. Understandably, since the sampled energy storage battery has multiple calibrated discharge energies, multiple sampled capacity degradation rates may be obtained correspondingly. The calculation formula for the capacity degradation rate is as follows:

$$\text{ELR} = \frac{E_r - E_i}{E_r} \times 100\%$$

Wherein, ELR is the capacity degradation rate of the sampled energy storage battery, $E_r$ is the rated energy of the sampled energy storage battery, and $E_i$ is the calibrated discharge energy of the sampled energy storage battery.

Energy storage battery sampled data may be generated according to the plurality of sampled depths of charge-discharge, and the sampled capacity degradation rate and sampled cumulative discharge energy of the sampled energy storage battery under each sampled depth of charge-discharge

S202: Fitting the energy storage battery sampled data, and establishing a mapping relationship among the capacity degradation rate, the cumulative discharge energy, and the depth of charge-discharge corresponding to the energy storage battery.

The mapping relationship among the capacity degradation rate, the cumulative discharge energy, and the depth of charge-discharge corresponding to the energy storage battery is established by fitting the energy storage battery sampled data. The formula for the mapping relationship is as follows:

wherein, ELR is the capacity degradation rate, $Add_E$ is the cumulative discharge energy, x is the depth of discharge with a value range of 0-100%, and a, b, c, d are fitting parameters, which are obtained by fitting according to the test results. After the fitting parameters are determined, the mapping relationship among the capacity degradation rate, the cumulative discharge energy, and the depth of charge-discharge of the energy storage battery is obtained.

S203: Obtaining the single cumulative discharge energy of the target energy storage battery in each discharge process from the first discharge to the current moment.

The single cumulative discharge energy of the target energy storage battery in each discharge process from the first discharge to the current moment may be obtained and denoted as $E_{dis\text{-}i}$, wherein i represents the i-th discharge.

S204: During each single discharge process of the target energy storage battery, obtaining discharge start moment of the target energy storage battery and an initial state of charge of the target energy storage battery at the discharge start moment, and obtaining discharge end moment of the target energy storage battery and the end state of charge of the target energy storage battery at the discharge end moment.

During each single discharge process of the target energy storage battery, the discharge start moment of the target energy storage battery, the initial state of charge of the target energy storage battery at the discharge start moment,the discharge end moment of the target energy storage battery and the end state of charge of the target energy storage battery at the discharge end moment are obtained.

In some embodiments, the initial state of charge of the target energy storage battery at the discharge start moment may be obtained as 60%, and the end state of charge of the target energy storage battery at the discharge end moment may be obtained as 15%.

S205: Determining difference between the initial state of charge and the end state of charge as the single depth of discharge corresponding to the target energy storage battery in the current discharge process.

The difference between the initial state of charge and the end state of charge may be obtained, and be determined as the single depth of discharge corresponding to the target energy storage battery in the current discharge process.

In some embodiments, based on the initial state of charge of the target energy storage battery at the discharge start moment is 60% and the end state of charge of the target energy storage battery at the discharge end moment is 15%, the single depth of discharge corresponding to the target energy storage battery in the current discharge process is 60%-15% = 45%.

S206: Obtaining the single capacity degradation rate of the target energy storage battery based on the single cumulative discharge energy, the single depth of discharge, and the mapping relationship.

The single capacity degradation rate of the target energy storage battery may be obtained by substituting the single cumulative discharge energy and the single depth of discharge into the mapping relationship.

Wherein, $E_{l-i}$ represents the single capacity degradation rate of the target energy storage battery in the i-th single discharge process, $E_{dis-i}$ represents the single cumulative discharge energy of the target energy storage battery in the i-th single discharge process, $x_i$ represents the single depth of discharge of the target energy storage battery in the i-th single discharge process, and a, b, c, d are fitting parameters.

S207: Obtaining the average single capacity degradation rate of the target energy storage battery.

The average single capacity degradation rate of the target energy storage battery may be obtained and denoted as $E_{l-a}$.

In some embodiments, the method for obtaining the average single capacity degradation rate $E_{l-a}$ includes: obtaining the sum $\sum_{i=1}^{n} E_{l-i}$ of all single capacity degradation rate $E_{l-i}$ corresponding to each discharge process of the target energy storage battery from the first discharge to the current moment; obtaining the total number of discharges n of the target energy storage battery from the first discharge to the current moment; determining the quotient of the sum and the total number of discharges as the average single capacity degradation rate $E_{l-a} = \dfrac{\sum_{i=1}^{n} E_{l-i}}{n}$ .

In some embodiments, the method for obtaining the average single capacity degradation rate $E_{l-a}$ includes: calculating average of the single depth of discharge of the target energy storage battery in each discharge process from the first discharge to the current moment to obtain the average depth of discharge $x_a$ of the target energy storage battery from the first discharge to the current moment; calculating average of the single cumulative discharge energy of the target energy storage battery in each discharge process from the first discharge to the current moment to obtain the average single cumulative discharge energy $E_{dis-a}$ of the target energy storage battery from the first discharge to the current moment; and obtaining the average single capacity degradation rate based on the average depth of discharge, the average single cumulative discharge energy and the mapping relationship. The formula is as follows:

Wherein $E_{l-a}$ represents the average single capacity degradation rate of the target energy storage battery, $E_{dis-a}$ represents the average single cumulative discharge energy, $x_a$ represents the average depth of discharge, and a, b, c, d are fitting parameters.

S208: Obtaining sum of all single capacity degradation rates corresponding to each discharge process of the target energy storage battery from the first discharge to the current moment, and determining the sum as the current capacity degradation rate.

The sum of all single capacity degradation rates corresponding to each discharge process of the target energy storage battery from the first discharge to the current moment may be obtained and determined as as the current capacity degradation rate, which is denoted as $E_{l-c}$. The calculation formula for the current capacity degradation rate is as follows:

Wherein, $E_{l-c}$ represents the current capacity degradation rate of the target energy storage battery, $E_{dis-i}$ represents the single cumulative discharge energy of the target energy storage battery in the i-th single discharge process, $x_i$ represents the single depth of discharge of the target energy storage battery in the i-th single discharge process, and a, b, c, d are fitting parameters.

S209: Obtaining a preset maximum capacity degradation rate corresponding to the target energy storage battery, and obtaining the remaining useful life of the target energy storage battery by combining the current capacity degradation rate and the average single capacity degradation rate, wherein the remaining useful life refers to the remaining number of charge-discharge cycles of the target energy storage battery.

The preset maximum capacity degradation rate $E_{end}$ corresponding to the target energy storage battery may be obtained, and the remaining useful life of the target energy storage battery may be obtained by combining the current capacity degradation rate $E_{l-c}$ and the average single capacity degradation rate $E_{l-a}$, wherein the remaining useful life refers to the remaining number of charge-discharge cycles of the target energy storage battery. The calculation formula for the remaining useful life of the target energy storage battery is as follows:

Wherein, $L_r$ represents the remaining useful life of the target energy storage battery, $E_{end}$ represents the preset maximum capacity degradation rate corresponding to the target energy storage battery, $E_{l-c}$ represents the current capacity degradation rate of the target energy storage battery, and $E_{l-a}$ represents the average single capacity degradation rate corresponding to the target energy storage battery.

In the embodiments of the present disclosure, by conducting charge-discharge experiments on the sampled energy storage batteries under different depths of discharge, the mapping relationship among the capacity degradation rate, the cumulative discharge energy, and the depth of charge-discharge corresponding to the energy storage battery is established. Then, based on the single depth of discharge and single cumulative discharge energy of the target energy storage battery in each discharge process during its actual operation, the current capacity degradation rate of the target energy storage battery is estimated, thereby performing accurate online prediction of its remaining useful life.

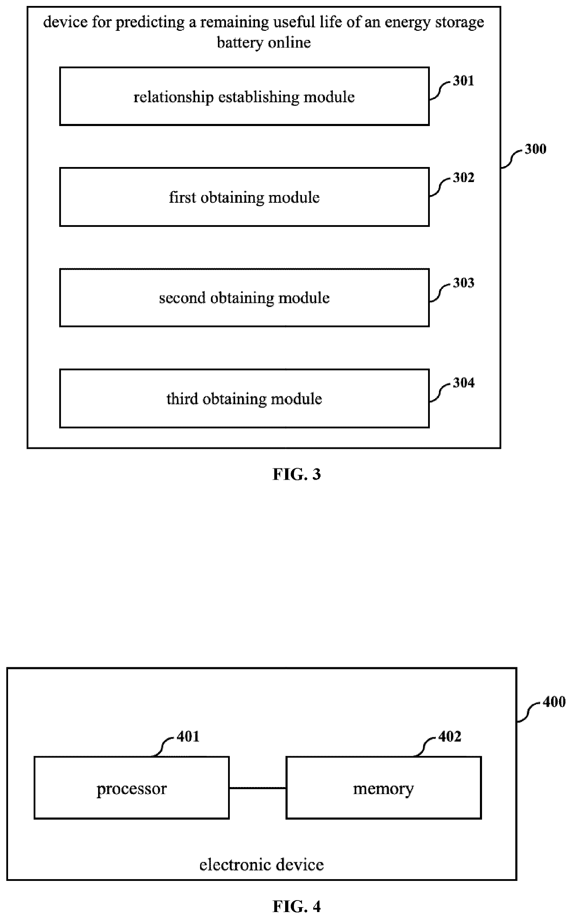

FIG. 3 is a schematic diagram of a device for predicting the remaining useful life of an energy storage battery online according to an embodiment of the second aspect of the present disclosure. As shown in FIG. 3, the device 300 for predicting the remaining useful life of an energy storage battery online includes a relationship establishing module 301, a first obtaining module 302, a second obtaining module 303, and a third obtaining module 304.

The relationship establishing module 301 is configured to obtain energy storage battery sampled data corresponding to a plurality of identical sampled energy storage batteries under different sampled depths of charge-discharge respectively, and establish a mapping relationship among a capacity degradation rate, cumulative discharge energy, and a depth of charge-discharge corresponding to the energy storage battery according to the energy storage battery sampled data.

The first obtaining module 302 is configured to obtain single depth of discharge and single cumulative discharge energy of the target energy storage battery in each discharge process from a first discharge to a current moment, and obtain a single capacity degradation rate of the target energy storage battery and an average single capacity degradation rate of the target energy storage battery according to the single cumulative discharge energy, the single depth of discharge and the mapping relationship.

The second obtaining module 303 is configured to obtain a current capacity degradation rate corresponding to the current moment of the target energy storage battery according to the single capacity degradation rate corresponding to each discharge process of the target energy storage battery.

The third obtaining module 304 is configured to obtain a preset maximum capacity degradation rate corresponding to the target energy storage battery, and obtain the remaining useful life of the target energy storage battery by combining the current capacity degradation rate and the average single capacity degradation rate, wherein the remaining useful life refers to a remaining number of charge-discharge cycles of the target energy storage battery.

The present device establishes the mapping relationship among the capacity degradation rate, the cumulative discharge energy, and the depth of charge-discharge corresponding to the energy storage battery by conducting charge-discharge experiments on the sampled energy storage batteries under different depths of discharge. And then, based on the single depth of discharge and single cumulative discharge energy of the target energy storage battery in each discharge process during its actual operation, the present device may estimate the current capacity degradation rate of the target energy storage battery is estimated, thereby performing accurate online prediction of its remaining useful life.

According to one embodiment of the present disclosure, the relationship establishing module is further configured to fit the energy storage battery sampled data to establish the mapping relationship among the capacity degradation rate, the cumulative discharge energy, and the depth of charge-discharge corresponding to the energy storage battery, wherein each sampled energy storage battery corresponds to one sampled depth of charge-discharge, and the energy storage battery sampled data comprises sampled depth of charge-discharge corresponding to each sampled energy storage battery, sampled capacity degradation rate and sampled cumulative discharge energy of each sampled energy storage battery under corresponding sampled depth of charge-discharge.

According to one embodiment of the present disclosure, the relationship establishing module is further configured to: perform cyclic charge-discharge on the plurality of the sampled energy storage batteries at different sampled depths of charge-discharge respectively with a specific power; for any one of the sampled energy storage batteries, after a preset number of cycles, perform energy calibration on the sampled energy storage battery, and record calibrated discharge energy of the sampled energy storage battery under corresponding sampled depths of charge-discharge, wherein the calibrated discharge energy refers to total energy released by the sampled energy storage battery from a fully charged state to a fully discharged state during calibration; obtain rated energy of the sampled energy storage battery; For any one of the sampled energy storage batteries, obtain the sampled capacity degradation rate of the sampled energy storage battery under the corresponding sampled depth of charge-discharge according to the calibrated discharge energy and the rated energy of the sampled energy storage battery under the corresponding sampled depth of charge-discharge; and generate the energy storage battery sampled data according to the plurality of sampled depth of charge-discharge, and the sampled capacity degradation rate and sampled cumulative discharge energy of the sampled energy storage battery under each of the sampled depth of charge-discharge.

According to one embodiment of the present disclosure, the first obtaining module is further configured to: during each single discharge process of the target energy storage battery, obtain discharge start moment of the target energy storage battery and an initial state of charge of the target energy storage battery at the discharge start moment, and obtain discharge end moment of the target energy storage battery and the end state of charge of the target energy storage battery at the discharge end moment; and determine difference between the initial state of charge and the end state of charge as the single depth of discharge corresponding to the target energy storage battery in the current discharge process.

According to one embodiment of the present disclosure, the first obtaining module is further configured to: obtain sum of all the single capacity degradation rates corresponding to each discharge process of the target energy storage battery from the first discharge to the current moment; obtain a total number of discharges of the target energy storage battery from the first discharge to the current moment; and determine quotient of the sum and the total number of discharges as the average single capacity degradation rate.

According to one embodiment of the present disclosure, the first obtaining module is further configured to: calculate average of the single depths of discharge in each discharge process of the target energy storage battery from the first discharge to the current moment to obtain the average depth of discharge of the target energy storage battery from the first discharge to the current moment; calculate average of the single cumulative discharge energies in each discharge process of the target energy storage battery from the first discharge to the current moment to obtain the average single cumulative discharge energy of the target energy storage battery from the first discharge to the current moment; and obtain the average single capacity degradation rate according to the average depth of discharge, the average single cumulative discharge energy and the mapping relationship.

According to one embodiment of the present disclosure, the second obtaining module is further configured to obtain sum of all the single capacity degradation rates corresponding to each discharge process of the target energy storage battery from the first discharge to the current moment, and determine the sum as the current capacity degradation rate.

In order to implement the above embodiments, an embodiment of the third aspect of the present disclosure further provides an electronic device 400. As shown in FIG. 4, the electronic device 400 includes: a processor 401 and a memory 402 communicatively connected to the processor. The memory 402 stores instructions executable by at least one processor, and the instructions are executed by at least one processor 401 to implement the method for predicting the remaining useful life of the energy storage battery online as shown in any one of the embodiments of the first aspect.

In order to implement the above embodiments, an embodiment of the fourth aspect of the present disclosure further provides a non-transitory computer-readable storage medium storing computer instructions, wherein the computer instructions are used to cause a computer to implement the method for predicting the remaining useful life of the energy storage battery online as shown in any one of the embodiments of the first aspect.

In order to implement the above embodiments, an embodiment of the fifth aspect of the present disclosure further provides a computer program product, including a computer program, which, when executed by a processor, implements the method for predicting the remaining useful life of the energy storage battery online as shown in any one of the embodiments of the first aspect.

In order to implement the above embodiments, an embodiment of the sixth aspect of the present disclosure provides a computer program, including computer program code, which, when run on a computer, causes the computer to execute the method for predicting the remaining useful life of the energy storage battery online as shown in any one of the embodiments of the first aspect.

It should be noted that the explanations and descriptions of the method for predicting the remaining useful life of the energy storage battery online in the aforementioned embodiments are also applicable to the computer-readable storage medium, computer program product, and computer program of the embodiments of the present disclosure, and will not be repeated here.

All embodiments of the present disclosure may be implemented independently or in combination with other embodiments, and all are deemed to fall within the protection scope claimed by the present disclosure.

In addition, the terms "first" and "second" are only used for descriptive purposes, and shall not be construed as indicating or implying relative importance or implicitly specifying the quantity of the indicated technical features. Therefore, a feature defined with "first" or "second" may explicitly or implicitly include one or more of such features. In the description of the present disclosure, the meaning of "plurality" is two or more, unless otherwise explicitly and specifically defined.

In the description of the specification, references to the terms "one embodiment", "some embodiments", "example", "specific example", or "some examples" etc., mean that a specific feature, structure, material, or characteristic described in connection with the embodiment or example is included in at least one embodiment or example of the present disclosure. In this specification, the schematic representations of the above terms are not necessarily directed to the same embodiment or example. Furthermore, the described specific features, structures, materials, or characteristics may be combined in any suitable manner in any one or more embodiments or examples. In addition, those skilled in the art may combine and merge different embodiments or examples and the features of different embodiments or examples described in this specification without conflicting with each other.

Although the embodiments of the present disclosure have been shown and described above, it can be understood that the above embodiments are exemplary and shall not be construed as limiting the present disclosure. Those of ordinary skill in the art may make changes, modifications, substitutions, and variations to the above embodiments within the scope of the present disclosure.

**Claims**

1.  A method for predicting a remaining useful life of an energy storage battery online, comprising:

    obtaining energy storage battery sampled data corresponding to a plurality of identical sampled energy storage batteries under different sampled depths of charge-discharge respectively, and establishing a mapping relationship among a capacity degradation rate, cumulative discharge energy, and a depth of charge-discharge corresponding to the energy storage battery according to the energy storage battery sampled data, wherein the expression of the mapping relationship is:

    $$ELR = \frac{Add_E}{ax^3 + bx^2 + cx + d}$$

    wherein, ELR is the capacity degradation rate, $Add_E$ is the cumulative discharge energy, x is the depth of discharge with a value range of 0-100%, and a, b, c, d are fitting parameters;
    obtaining single depth of discharge and single cumulative discharge energy of a target energy storage battery in each discharge process from a first discharge to a current moment, and obtaining a single capacity degradation rate of the target energy storage battery and an average single capacity degradation rate of the target energy storage battery according to the single cumulative discharge energy, the single depth of discharge and the mapping relationship;
    obtaining a current capacity degradation rate corresponding to the current moment of the target energy storage battery according to the single capacity degradation rate corresponding to each discharge process of the target energy storage battery; and
    obtaining a preset maximum capacity degradation rate corresponding to the target energy storage battery, and obtaining the remaining useful life of the target energy storage battery by combining the current capacity degradation rate and the average single capacity degradation rate, wherein the remaining useful life refers to a remaining number of charge-discharge cycles of the target energy storage battery.

2.  The method according to claim 1, wherein establishing the mapping relationship among the capacity degradation rate, the cumulative discharge energy, and the depth of charge-discharge corresponding to the energy storage battery according to the energy storage battery sampled data comprises:
    fitting the energy storage battery sampled data to establish the mapping relationship among the capacity degradation rate, the cumulative discharge energy, and the depth of charge-discharge corresponding to the energy storage battery, wherein each sampled energy storage battery corresponds to one sampled depth of charge-discharge, and the energy storage battery sampled data comprises sampled depth of charge-discharge corresponding to each sampled energy storage battery, sampled capacity degradation rate and sampled cumulative discharge energy of each sampled energy storage battery under corresponding sampled depth of charge-discharge.

3.  The method according to claim 1 or 2, wherein obtaining the energy storage battery sampled data corresponding to a plurality of identical sampled energy storage batteries under different sampled depths of charge-discharge respectively comprises:

    performing cyclic charge-discharge on the plurality of the sampled energy storage batteries at different sampled depths of charge-discharge respectively with a specific power; for any one of the sampled energy storage batteries, after a preset number of cycles, performing energy calibration on the sampled energy storage battery, and recording calibrated discharge energy of the sampled energy storage battery under corresponding sampled depths of charge-discharge, wherein the calibrated discharge energy refers to total energy released by the sampled energy storage battery from a fully charged state to a fully discharged state during calibration; obtaining rated energy of the sampled energy storage battery;

For any one of the sampled energy storage batteries, obtaining the sampled capacity degradation rate of the sampled energy storage battery under the corresponding sampled depth of charge-discharge according to the calibrated discharge energy and the rated energy of the sampled energy storage battery under the corresponding sampled depth of charge-discharge; and

generating the energy storage battery sampled data according to the plurality of sampled depth of charge-discharge, and the sampled capacity degradation rate and sampled cumulative discharge energy of the sampled energy storage battery under each of the sampled depth of charge-discharge.

4. The method according to any one of claims 1 to 3, wherein obtaining the single depth of discharge of the target energy storage battery in each discharge process from the first discharge to the current moment comprises:

during each single discharge process of the target energy storage battery, obtaining discharge start moment of the target energy storage battery and an initial state of charge of the target energy storage battery at the discharge start moment, and obtaining discharge end moment of the target energy storage battery and the end state of charge of the target energy storage battery at the discharge end moment; and

determining difference between the initial state of charge and the end state of charge as the single depth of discharge corresponding to the target energy storage battery in the current discharge process.

5. The method according to any one of claims 1 to 4, wherein obtaining the average single capacity degradation rate comprises:

obtaining sum of all the single capacity degradation rates corresponding to each discharge process of the target energy storage battery from the first discharge to the current moment;

obtaining a total number of discharges of the target energy storage battery from the first discharge to the current moment; and

determining quotient of the sum and the total number of discharges as the average single capacity degradation rate.

6. The method according to any one of claims 1 to 4, wherein obtaining the average single capacity degradation rate comprises:

calculating average of the single depths of discharge in each discharge process of the target energy storage battery from the first discharge to the current moment to obtain the average depth of discharge of the target energy storage battery from the first discharge to the current moment;

calculating average of the single cumulative discharge energies in each discharge process of the target energy storage battery from the first discharge to the current moment to obtain the average single cumulative discharge energy of the target energy storage battery from the first discharge to the current moment; and

obtaining the average single capacity degradation rate according to the average depth of discharge, the average single cumulative discharge energy and the mapping relationship.

7. The method according to any one of claims 1 to 6, wherein obtaining the current capacity degradation rate corresponding to the current moment of the target energy storage battery according to the single capacity degradation rate corresponding to each discharge process of the target energy storage battery comprises:
obtaining sum of all the single capacity degradation rates corresponding to each discharge process of the target energy storage battery from the first discharge to the current moment, and determining the sum as the current capacity degradation rate.

8. A device for predicting a remaining useful life of an energy storage battery online, comprising:

a relationship establishing module, configured to obtain energy storage battery sampled data corresponding to a plurality of identical sampled energy storage batteries under different sampled depths of charge-discharge respectively, and establish a mapping relationship among a capacity degradation rate, cumulative discharge energy, and a depth of charge-discharge corresponding to the energy storage battery according to the energy storage battery sampled data, wherein the expression of the mapping relationship is:

$$ELR = \frac{Add_E}{ax^3 + bx^2 + cx + d}$$

wherein, ELR is the capacity degradation rate, AddE is the cumulative discharge energy, x is the depth of discharge with a value range of 0-100%, and a, b, c, d are fitting parameters;

a first obtaining module, configured to obtain single depth of discharge and single cumulative discharge energy of a target energy storage battery in each discharge process from a first discharge to a current moment, and obtain a single capacity degradation rate of the target energy storage battery and an average single capacity degradation rate of the target energy storage battery according to the single cumulative discharge energy, the single depth of discharge and the mapping relationship;

a second obtaining module, configured to obtain a current capacity degradation rate corresponding to the current moment of the target energy storage battery according to the single capacity degradation rate corresponding to each discharge process of the target energy storage battery; and

a third obtaining module, configured to obtain a preset maximum capacity degradation rate corresponding to the target energy storage battery, and obtain the remaining useful life of the target energy storage battery by combining the current capacity degradation rate and the average single capacity degradation rate, wherein the remaining useful life refers to a remaining number of charge-discharge cycles of the target energy storage battery.

9. The device according to claim 8, wherein the relationship establishing module is further configured to fit the energy storage battery sampled data to establish the mapping relationship among the capacity degradation rate, the cumulative discharge energy, and the depth of charge-discharge corresponding to the energy storage battery, wherein each sampled energy storage battery corresponds to one sampled depth of charge-discharge, and the energy storage battery sampled data comprises sampled depth of charge-discharge corresponding to each sampled energy storage battery, sampled capacity degradation rate and sampled cumulative discharge energy of each sampled energy storage battery under corresponding sampled depth of charge-discharge.

10. The device according to claim 8 or 9, wherein the relationship establishing module is further configured to:

perform cyclic charge-discharge on the plurality of the sampled energy storage batteries at different sampled depths of charge-discharge respectively with a specific power; for any one of the sampled energy storage batteries, after a preset number of cycles, perform energy calibration on the sampled energy storage battery, and record calibrated discharge energy of the sampled energy storage battery under corresponding sampled depths of charge-discharge, wherein the calibrated discharge energy refers to total energy released by the sampled energy storage battery from a fully charged state to a fully discharged state during calibration;

obtain rated energy of the sampled energy storage battery;

For any one of the sampled energy storage batteries, obtain the sampled capacity degradation rate of the sampled energy storage battery under the corresponding sampled depth of charge-discharge according to the calibrated discharge energy and the rated energy of the sampled energy storage battery under the corresponding sampled depth of charge-discharge; and

generate the energy storage battery sampled data according to the plurality of sampled depth of charge-discharge, and the sampled capacity degradation rate and sampled cumulative discharge energy of the sampled energy storage battery under each of the sampled depth of charge-discharge.

11. The device according to any one of claims 8 to 10, wherein the first obtaining module is further configured to:

during each single discharge process of the target energy storage battery, obtain discharge start moment of the target energy storage battery and an initial state of charge of the target energy storage battery at the discharge start moment, and obtain discharge end moment of the target energy storage battery and the end state of charge of the target energy storage battery at the discharge end moment; and

determine difference between the initial state of charge and the end state of charge as the single depth of discharge corresponding to the target energy storage battery in the current discharge process.

12. The device according to any one of claims 8 to 11, wherein the first obtaining module is further configured to:

obtain sum of all the single capacity degradation rates corresponding to each discharge process of the target energy storage battery from the first discharge to the current moment;

obtain a total number of discharges of the target energy storage battery from the first discharge to the current moment; and

determine quotient of the sum and the total number of discharges as the average single capacity degradation rate.

13. The method according to any one of claims 6 to 11, wherein the first obtaining module is further configured to:

calculate average of the single depths of discharge in each discharge process of the target energy storage battery from the first discharge to the current moment to obtain the average depth of discharge of the target energy storage battery from the first discharge to the current moment;

calculate average of the single cumulative discharge energies in each discharge process of the target energy storage battery from the first discharge to the current moment to obtain the average single cumulative discharge energy of the target energy storage battery from the first discharge to the current moment; and

obtain the average single capacity degradation rate according to the average depth of discharge, the average single cumulative discharge energy and the mapping relationship.

14. The device according to any one of claims 8 to 13, wherein the second obtaining module is further configured to obtain sum of all the single capacity degradation rates corresponding to each discharge process of the target energy storage battery from the first discharge to the current moment, and determine the sum as the current capacity degradation rate.

15. An electronic device, comprising:

at least one processor; and

a memory communicatively connected to the at least one processor; wherein the memory stores instructions executable by the at least one processor, and the instructions are executed by the at least one processor, enabling the at least one processor to execute the method according to any one of claims 1 to 7.

16. A non-transitory computer-readable storage medium storing computer instructions, wherein the computer instructions are used to cause computer to execute the method according to any one of claims 1 to 7.

17. A computer program product, comprising a computer program, which, when executed by a processor, implements the method according to any one of claims 1 to 7.

18. A computer program, comprising computer program code, which, when run on a computer, causes the computer to execute the method according to any one of claims 1 to 7.

obtaining energy storage battery sampled data corresponding to a plurality of identical sampled energy storage batteries under different sampled depths of charge-discharge respectively, and establishing a mapping relationship among a capacity degradation rate, cumulative discharge energy, and a depth of charge-discharge corresponding to the energy storage battery according to the energy storage battery sampled data — S101

obtaining single depth of discharge and single cumulative discharge energy of the target energy storage battery in each discharge process from a first discharge to a current moment, and obtaining a single capacity degradation rate of the target energy storage battery and an average single capacity degradation rate of the target energy storage battery according to the single cumulative discharge energy, the single depth of discharge and the mapping relationship — S102

obtaining a current capacity degradation rate corresponding to the current moment of the target energy storage battery according to the single capacity degradation rate corresponding to each discharge process of the target energy storage battery — S103

obtaining a preset maximum capacity degradation rate corresponding to the target energy storage battery, and obtaining the remaining useful life of the target energy storage battery by combining the current capacity degradation rate and the average single capacity degradation rate, wherein the remaining useful life refers to a remaining number of charge-discharge cycles of the target energy storage battery — S104

**FIG. 1**

obtaining energy storage battery sampled data corresponding to a plurality of identical sampled energy storage batteries under different sampled depths of charge-discharge respectively — S201

fitting the energy storage battery sampled data, and establishing a mapping relationship among the capacity degradation rate, the cumulative discharge energy, and the depth of charge-discharge corresponding to the energy storage battery — S202

obtaining the single cumulative discharge energy of the target energy storage battery in each discharge process from the first discharge to the current moment — S203

during each single discharge process of the target energy storage battery, obtaining discharge start moment of the target energy storage battery and an initial state of charge of the target energy storage battery at the discharge start moment, and obtaining discharge end moment of the target energy storage battery and the end state of charge of the target energy storage battery at the discharge end moment — S204

determining difference between the initial state of charge and the end state of charge as the single depth of discharge corresponding to the target energy storage battery in the current discharge process — S205

obtaining the single capacity degradation rate of the target energy storage battery based on the single cumulative discharge energy, the single depth of discharge, and the mapping relationship — S206

Obtaining the average single capacity degradation rate of the target energy storage battery — S207

obtaining sum of all single capacity degradation rates corresponding to each discharge process of the target energy storage battery from the first discharge to the current moment, and determining the sum as the current capacity degradation rate — S208

Obtaining a preset maximum capacity degradation rate corresponding to the target energy storage battery, and obtaining the remaining useful life of the target energy storage battery by combining the current capacity degradation rate and the average single capacity degradation rate, wherein the remaining useful life refers to the remaining number of charge-discharge cycles of the target energy storage battery — S209

**FIG. 2**

device for predicting a remaining useful life of an energy storage battery online

relationship establishing module — 301

first obtaining module — 302

second obtaining module — 303

third obtaining module — 304

— 300

**FIG. 3**

processor — 401

memory — 402

— 400

electronic device

**FIG. 4**

## INTERNATIONAL SEARCH REPORT

| International application No. |
|---|
| **PCT/CN2024/080225** |

### A. CLASSIFICATION OF SUBJECT MATTER

G01R31/367(2019.01)i; G01R31/392(2019.01)i; G01R31/382(2019.01)i

According to International Patent Classification (IPC) or to both national classification and IPC

### B. FIELDS SEARCHED

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

CNABS: CNTXT; CNKI; VEN; USTXT; EPTXT; WOTXT; IEEE: 华能集团清洁能源, 段召容, 刘明义, 曹传钊, 曹曦, 裴杰, 成前, 平小凡, 杨超然, 王璐瑶, 电池, 寿命, 剩余, 放电深度, 衰减, 衰退, DOD, battery, life, remain, depth of discharge, attenuation

### C. DOCUMENTS CONSIDERED TO BE RELEVANT

| Category* | Citation of document, with indication, where appropriate, of the relevant passages | Relevant to claim No. |
|---|---|---|
| PX | CN 116047311 A (CHINA HUANENG GROUP CLEANING ENERGY TECHNOLOGY RESEARCH INSTITUTE CO., LTD. et al.) 02 May 2023 (2023-05-02) description, paragraphs [0032]-[0087] | 1-18 |
| A | CN 107478999 A (NINGBO INSTITUTE OF MATERIAL TECHNOLOGY AND ENGINEERING, CHINESE ACADEMY OF SCIENCES) 15 December 2017 (2017-12-15) description, paragraphs [0047]-[0101], and figures 1 and 5 | 1-18 |
| A | CN 111562510 A (CHINA ELECTRIC POWER RESEARCH INSTITUTE CO., LTD. et al.) 21 August 2020 (2020-08-21) entire document | 1-18 |
| A | CN 105738814 A (STATE GRID CORP. OF CHINA et al.) 06 July 2016 (2016-07-06) entire document | 1-18 |
| A | CN 111983456 A (BEIJING INSTITUTE OF TECHNOLOGY XINYUAN INFORMATION TECHNOLOGY CO., LTD.) 24 November 2020 (2020-11-24) entire document | 1-18 |

| ☑ Further documents are listed in the continuation of Box C. | ☑ See patent family annex. |
|---|---|

```
*    Special categories of cited documents:
"A"  document defining the general state of the art which is not considered
     to be of particular relevance
"D"  document cited by the applicant in the international application
"E"  earlier application or patent but published on or after the international
     filing date
"L"  document which may throw doubts on priority claim(s) or which is
     cited to establish the publication date of another citation or other
     special reason (as specified)
"O"  document referring to an oral disclosure, use, exhibition or other
     means
"P"  document published prior to the international filing date but later than
     the priority date claimed
```

```
"T"  later document published after the international filing date or priority
     date and not in conflict with the application but cited to understand the
     principle or theory underlying the invention
"X"  document of particular relevance; the claimed invention cannot be
     considered novel or cannot be considered to involve an inventive step
     when the document is taken alone
"Y"  document of particular relevance; the claimed invention cannot be
     considered to involve an inventive step when the document is
     combined with one or more other such documents, such combination
     being obvious to a person skilled in the art
"&"  document member of the same patent family
```

| Date of the actual completion of the international search | Date of mailing of the international search report |
|---|---|
| **30 May 2024** | **05 June 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2024/080225** |

### C. DOCUMENTS CONSIDERED TO BE RELEVANT

| Category* | Citation of document, with indication, where appropriate, of the relevant passages | Relevant to claim No. |
| --- | --- | --- |
| A | WO 2018112818 A1 (SHENZHEN ZNV TECHNOLOGY CO., LTD.) 28 June 2018 (2018-06-28)<br>    entire document | 1-18 |
| A | JP 2003297435 A (HONDA MOTOR CO., LTD.) 17 October 2003 (2003-10-17)<br>    entire document | 1-18 |

Form PCT/ISA/210 (second sheet) (July 2022)

## INTERNATIONAL SEARCH REPORT
### Information on patent family members

International application No.

**PCT/CN2024/080225**

| Patent document cited in search report | | | Publication date (day/month/year) | Patent family member(s) | | | Publication date (day/month/year) |
|---|---|---|---|---|---|---|---|
| CN | 116047311 | A | 02 May 2023 | None | | | |
| CN | 107478999 | A | 15 December 2017 | None | | | |
| CN | 111562510 | A | 21 August 2020 | None | | | |
| CN | 105738814 | A | 06 July 2016 | None | | | |
| CN | 111983456 | A | 24 November 2020 | None | | | |
| WO | 2018112818 | A1 | 28 June 2018 | None | | | |
| JP | 2003297435 | A | 17 October 2003 | JP | 3949488 | B2 | 25 July 2007 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2023102013429